# FASCICULE DE BREVET EUROPEEN

(11) **EP 3 039 439 B1**
(45) Date de publication et mention de la délivrance du brevet: **27.12.2017**
(21) Numéro de dépôt: 14756046.0
(22) Date de dépôt: 27.08.2014
(51) Int. Cl.: G01R 31/40

(54) **DETECTION D'ARCS ELECTRIQUES DANS LES INSTALLATIONS PHOTOVOLTAÏQUES**
ERKENNUNG VON LICHTBÖGEN IN PHOTOVOLTAIKANLAGEN
ELECTRIC ARC DETECTION IN PHOTOVOLTAIC INSTALLATIONS

(30) Priorité: 29.08.2013 FR 1358268
(43) Date de publication de la demande: 06.07.2016
(73) Titulaire: Commissariat à l'Énergie Atomique et aux Énergies Alternatives, 75015 Paris (FR)
(72) Inventeur: CHAINTREUIL, Nicolas, F-73800 Montmelian (FR); FASIELLO, Annalaura, F-73800 Chambery (FR); PLISSONNIER, Alexandre, F-38800 Pont-de-Claix (FR)
(74) Mandataire: Brevalex
(86) Numéro de dépôt international: PCT/EP2014/068170
(87) Numéro de publication internationale: WO 2015/028508

(56) Documents cités:
- US-A1- 2011 141 644
- US-A1- 2012 118 348
- US-A1- 2012 174 961

## Description

### DOMAINE TECHNIQUE ET ART ANTERIEUR

L'invention concerne les installations photovoltaïques et, en particulier, les moyens de détection d'arcs électriques dans ces installations.

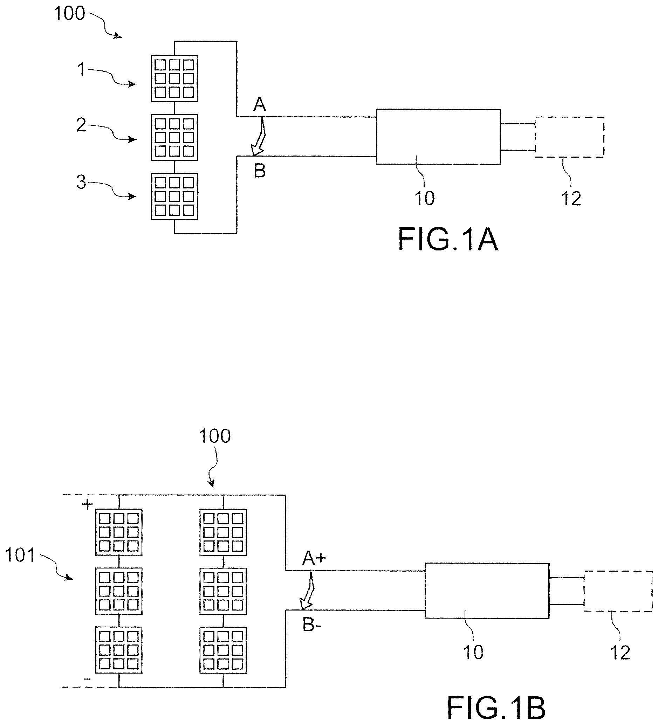

Les installations utilisant des panneaux photovoltaïques (PV) sont appelées à se développer. Or ce type de dispositif vieillit et des défaillances peuvent apparaître au cours du temps. Celles-ci peuvent être bénignes (par exemple : arrêt de fonctionnement, perte de production, baisse du rendement...) mais peuvent aussi être plus graves si un arc électrique apparaît. En effet, la conséquence d'un tel phénomène peut être, dans le pire des cas, un départ d'incendie pouvant aller jusqu'à la destruction du bâtiment dans lequel un module PV est installé. Le document US2011/141644A décrit un procédé de détection d'un arc dans un dispositif photovoltaïque. La figure 1A représente une installation la photovoltaïques de type connu, avec une chaine 100 de 3 modules photovoltaïques 1, 2, 3 et un convertisseur (ou onduleur) 10, relié au réseau électrique 12. Cette représentation est simplifiée, car une chaine comporte en général plus de 3 modules. En outre, une installation peut comporter plusieurs chaines 100, 101, ....disposées en parallèle, comme illustré en figure 1B.

Un arc électrique parallèle peut notamment se produire :
- aux bornes d'une ou de plusieurs chaines, par exemple entre les points A et B de la figure 1B, entre les modules photovoltaïques et l'onduleur 10 ;
- ou aux bornes d'un ou de plusieurs modules ;

Un arc électrique série peut se produire :
- entre une extrémité d'une quelconque des chaines et les moyens convertisseurs 10 ;
- dans une chaîne de modules ;
- ou dans un module PV.

On cherche donc à développer des systèmes permettant de détecter les arcs électriques, de type parallèle ou série, dès leur apparition.

Des solutions connues de détection d'arcs électriques dans les installations basse tension en courant continu ou alternatif sont principalement basées sur une détection ultrasonore (par signature acoustique de l'arc) ou radiofréquence (par signature RF de l'arc) ou encore sur des mesures thermiques (signature infrarouge de l'arc). La signature d'un phénomène est l'ensemble des caractéristiques et de leurs valeurs qui permet de l'identifier de façon certaine.

Pour les installations PV, le même type de détecteur commence à être développé par certains laboratoires ou industriels.

La principale contrainte de ces systèmes repose sur leur moyen de mesure de la signature. En effet, les signatures étant complexes et généralement à des fréquences élevées (pour les signatures acoustiques et RF) elles nécessitent un traitement logiciel très lourd, avec un échantillonnage élevé, et donc des composants coûteux. De plus, le temps de traitement, incluant une discrimination du bruit ou des perturbations par rapport à la signature de l'arc, peut être élevé, allant de quelques secondes à quelques minutes.

Ces solutions ne répondent donc pas à un besoin de mise en sécurité rapide, fiable et à bas coût.

En outre, on souhaite pouvoir détecter, dans un même dispositif, tant les arcs parallèles que les arcs de type série.

On connait des méthodes pour détecter des arcs électriques série dans un système PV, mais ces méthodes ne sont pas adaptées pour détecter des arcs parallèles.

Par exemple, le document FR 2912848 décrit comment détecter un arc série en utilisant la mesure d'une variation rapide de la tension.

Le document WO2011/17721 décrit une méthode basée sur une mesure moyenne du courant, dont l'évolution est observée. Cette solution nécessite une mesure longue et un traitement long.

Le document WO2011/11711 décrit une méthode basée sur une comparaison d'une signature de courant et d'une signature de tension sur un convertisseur de puissance pour module photovoltaïque. Le fait de devoir comparer le courant et la tension implique une puissance de calcul et des moyens de mesure évolués, donc coûteux.

On connait d'autres techniques pour détecter un arc, mais elles ne sont pas nécessairement compatibles avec des dispositifs dans le cas où ceux-ci fonctionnent en continu. Ainsi, le document US2008/180866 traite d'une détection d'arcs électriques sur une installation AC par mesure de courant. Son enseignement n'est pas applicable au cas d'une installation qui peut éventuellement fonctionner en courant continu.

Le document US2010085669 traite d'un détecteur d'arcs électriques basé sur un traitement logiciel et mathématique d'un signal de courant qui est amplifié et converti en valeurs numériques. Cette approche ne permet pas de répondre à un traitement rapide et simple.

Le document US6504692 décrit une méthode de détection des arcs électrique pour les systèmes AC. Cette détection est basée sur des variations de tension. Mais les paramètres de variation (amplitude, fréquence, temps de montée/descente...) ne sont pas les mêmes sur la partie DC d'une installation photovoltaïque.

L'enseignement de ce document n'est donc pas applicable au problème posé ici, qui est de trouver une méthode de caractérisation d'arcs électriques se produisant dans une installation photovoltaïque, y compris dans le cas d'un fonctionnement en courant continu.

En outre, les solutions proposées dans ce document sont complexes.

Or une solution à ce problème doit de préférence être rapide et simple, sans mettre en oeuvre des moyens coûteux.

Par ailleurs, il se pose en outre le problème de trouver une méthode de caractérisation d'arcs électriques, parallèle ou série, se produisant dans une installation photovoltaïque, permettant d'en estimer, d'une part, la nature (série ou parallèle) et, d'autre part, la position, dans une installation photovoltaïque.

### EXPOSÉ DE L'INVENTION

On décrit ici un procédé pour estimer la nature, série ou parallèle, et la localisation, d'un arc dans un dispositif photovoltaïque comportant N (N=1 ou N>1) chaînes de modules photovoltaïques, reliées à un dispositif de charge présentant un comportement capacitif pour les modules, ce procédé comportant les étapes suivantes :
a) mesurer, aux bornes de chacun des modules de chaque chaîne, l'évolution temporelle de la tension, au moins lors de la formation d'un arc électrique,
b) identifier les modules aux bornes desquels se produit une variation de tension entre une première durée (A) pendant laquelle la tension présente une pente sensiblement stable et une deuxième durée (B) pendant laquelle la tension présente une pente sensiblement stable pendant au moins 5µs, qui suit immédiatement ladite variation de tension, et identifier le sens, positif ou négatif, de chaque variation de tension,
c) estimer la nature, série ou parallèle, et la localisation, de l'arc dans le dispositif photovoltaïque, à partir de l'information sur les modules aux bornes desquels se produit une variation de tension, et le signe de chaque variation de tension.

Dans un tel procédé, il est en outre possible, avant l'étape c), et en vue de constater la présence effective d'un arc, d'estimer l'amplitude de la variation de tension et/ou la durée pendant laquelle cette variation se produit et/ou le taux moyen de cette variation.

Dans un tel procédé, lorsque la tension aux bornes de chacun des modules de chaque chaîne varie à la baisse, il peut être estimé qu'un arc parallèle se produit aux bornes principales du dispositif.

Par ailleurs, lorsque la tension aux bornes d'un modules d'une des chaînes du dispositif varie à la baisse, tandis que la tension aux bornes de chaque autre module de la même chaîne varie à la hausse, il peut être estimé qu'un arc parallèle se produit aux bornes dudit module ou qu'un arc série se produit à l'intérieur dudit module. Dans ce cas, lorsque la tension aux bornes dudit module varie à la baisse vers la valeur de tension d'arc, on peut estimer qu'un arc parallèle se produit aux bornes dudit module.

Dans ce même cas, lorsque la tension aux bornes dudit module varie à la baisse d'une valeur absolue sensiblement égale à V_{arc}/((1/n_{mod}) -1), où V_{arc} est la tension finale de l'arc, et n_{mod} est le nombre de modules dans la chaîne concernée, il est possible d'estimer qu'un arc série se produit à l'intérieur dudit module.

Lorsque la tension aux bornes de chacun des modules de chaque chaîne varie à la hausse, on peut estimer qu'un arc série se produit entre l'une des chaînes et ledit dispositif de charge.

Lorsque la tension aux bornes de chacun des modules d'une des chaînes varie à la hausse, une variation de tension n'étant pas constatée aux bornes des modules des autres chaînes, il peut être estimé qu'un arc série se produit à l'intérieur de ladite chaîne, mais pas à l'intérieur d'un des modules de cette même chaîne.

Enfin, si une diode est présente en tête de chaque chaîne, et dans lequel, lorsque la tension aux bornes de chacun des modules d'une 1^{ère} chaîne varie à la baisse, une variation de tension n'étant pas constatée aux bornes des modules des autres chaînes, il peut être estimé qu'un arc parallèle se produit entre la diode de la 1^{ère} chaîne et le dispositif de charge.

Selon une application particulière, le courant est continu.

L'invention concerne également un dispositif pour estimer la nature, série ou parallèle, et la localisation, d'un arc dans un système photovoltaïque comportant N (N=1 ou N>1) chaînes de modules photovoltaïques, reliées à un dispositif de charge présentant un comportement capacitif pour les modules, ce dispositif comportant :
a) des moyens de détection pour détecter, aux bornes de chacun des modules de chaque chaine, l'évolution temporelle de la tension lors de la formation d'un arc électrique,
b) des moyens pour identifier les modules aux bornes desquels au moins une variation de tension se produit, entre une première durée, pendant laquelle la tension présente une pente sensiblement stable et une deuxième durée, d'au moins 5µs, pendant laquelle la tension présente une pente sensiblement stable et qui suit immédiatement ladite variation de tension, et pour identifier le sens, positif ou négatif, de la variation de tension;
c) des moyens pour estimer la nature, série ou parallèle, et la localisation, de l'arc dans le dispositif photovoltaïque, à partir de l'information sur les modules aux bornes desquels se produit une variation de tension, et sur le signe de chaque variation de tension.

Un tel dispositif peut en outre comporter des moyens pour estimer l'amplitude de ladite variation et/ou la durée pendant laquelle cette variation se produit et/ou le taux moyen de cette variation, afin de constater la présence effective d'un arc.

De préférence, lorsque les moyens de détection aux bornes de chacun des modules de chaque chaîne détectent une variation à la baisse de la tension, il est estimé qu'un arc parallèle se produit aux bornes principales du dispositif.

De préférence encore, lorsque les moyens de détection aux bornes d'un module d'une des chaînes du dispositif détectent une variation à la baisse de la tension, tandis que les moyens de détection aux bornes de chaque autre module de la même chaîne détectent une variation à la hausse de la tension, il est estimé qu'un arc parallèle se produit aux bornes dudit module, ou qu'un arc série se produit à l'intérieur dudit module.

Dans ce cas, lorsque les moyens de détection aux bornes dudit module détectent une variation à la baisse de la tension vers la valeur de tension d'arc, il est possible d'estimer qu'un arc parallèle se produit aux bornes de celui-ci.

Dans ce même cas, lorsque les moyens de détection aux bornes dudit module détectent une variation à la baisse, d'une valeur absolue sensiblement égale à V_{arc}/((1/n_{mod}) -1), où V_{arc} est la tension finale de l'arc, et n_{mod} est le nombre de modules dans la chaîne concernée, il est possible d'estimer qu'un un arc série se produit à l'intérieur dudit module.

Par ailleurs, lorsque les moyens de détection aux bornes de chacun des modules de chaque chaîne détectent une variation à la hausse de la tension, il est peut être estimé qu'un arc série se produit entre l'une quelconque des chaînes et ledit dispositif de charge.

Lorsque les moyens de détection aux bornes de chacun des modules d'une chaîne détectent une variation positive de la tension, tandis que les moyens de détection aux bornes de chaque autre module des autres chaînes ne détectent pas de variation de tension, on peut estimer qu'un arc série se produit à l'intérieur d'une des chaînes, mais pas à l'intérieur d'un des modules de cette même chaîne.

Enfin, si une diode est présente en tête de chaque chaîne, lorsque la tension aux bornes de chacun des modules d'une 1^{ère} chaîne varie à la baisse, une variation de tension n'étant pas constatée aux bornes des modules des autres chaînes, il peut être estimé qu'un arc parallèle se produit entre la diode de la 1^{ère} chaîne et le dispositif de charge.

Dans un dispositif ou un procédé selon l'invention, on peut mettre en oeuvre des moyens pour filtrer des fréquences au moins égales à 100Hz.

Des moyens de filtrage formant filtre passif ou formant filtre actif et/ou des moyens de filtrage analogiques et/ou numériques peuvent être utilisés.

Des moyens peuvent être prévus pour numériser les tensions mesurées.

Le dispositif ou les moyens présentant un comportement capacitif pour les modules peut/peuvent comporter un convertisseur ou un onduleur ou une batterie.

Un arc, série ou parallèle, dont on cherche à estimer la nature, série ou parallèle, et la localisation, peut produire une variation de tension aux bornes de chacun de plusieurs modules du dispositif.

### BREVE DESCRIPTION DES FIGURES

- Les figures 1A et 1B représentent schématiquement des installations photovoltaïques de type connu,
- les figures 1C et 1D représentent schématiquement une structure générale d'une installation photovoltaïque, avec des moyens de mesure de tension détection, disposés aux bornes de chaque module photovoltaïque,
- la figure 1E est une représentation schématique d'un exemple de moyens interrupteurs pouvant être mis en oeuvre dans l'installation des figures 1C et 1D,
- la figure 2 représente des courbes courant/tension caractéristiques d'un module photovoltaïque,
- les figures 3A et 3B représentent les variations d'une tension, au cours du temps, lors d'un arc électrique parallèle aux bornes d'un dispositif photovoltaïque, la tension filtrée étant en outre représentée en figure 3B,
- les figures 4A - 4C représentent diverses configurations d'arcs électriques parallèles;
- la figure 5 représente les variations d'une tension, au cours du temps, lors d'un arc électrique série aux bornes d'un dispositif photovoltaïque,
- les figures 6A - 6C représentent diverses configurations d'arc électrique de type « série »;
- les figures 7A et 7B représentent un exemple de réalisation d'un procédé selon l'invention, et une variante de cet exemple de réalisation ;
- la figure 8 représente une portion d'un signal sinusoïdal, par exemple dans le cas d'un onduleur induisant des perturbations,
- la figure 9 représente un mode de réalisation de moyens numériques pour faire l'acquisition d'un signal et le traiter selon un procédé conforme à l'invention.
- les figures 10 et 11 représentent d'autres modes de réalisation de moyens d'acquisition et de traitement du signal, selon un procédé conforme à l'invention.

### EXPOSÉ DÉTAILLÉ DE MODES DE RÉALISATION PARTICULIERS

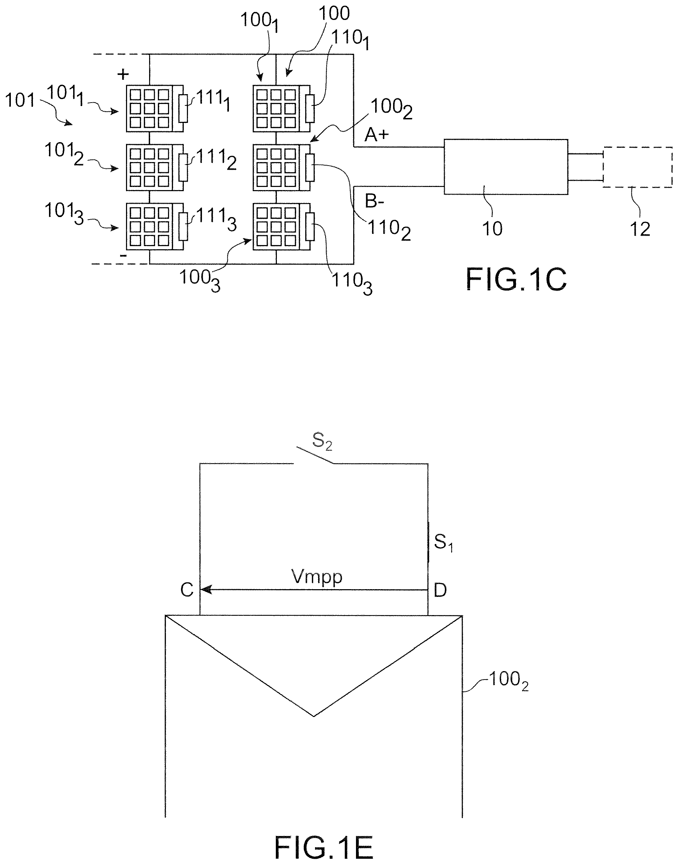

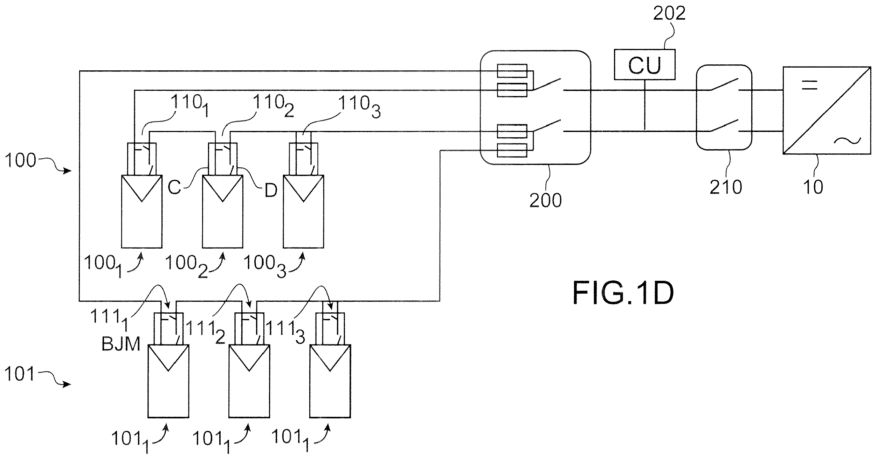

Les figures 1C et 1D représentent schématiquement la structure d'une installation photovoltaïque (on utilise également l'abréviation PV dans le reste de cette description), comportant 2 chaines 100, 101 de modules photovoltaïques 100₁, 100₂, 100₃, 101₁, 101₂, 101₃, les différents modules 100₁ - 100₃, 101₁ - 101₃ d'une même chaîne étant reliés en série. On appelle module photovoltaïque un assemblage monolithique de cellules photovoltaïques.

La présente description n'est pas limitée à une ou deux chaines comportant chacune trois modules photovoltaïques, mais s'applique à un nombre n_{mod} quelconque de ces modules dans une chaine et/ou à un nombre N_{c} quelconque de chaines.

Chacun des modules est muni de moyens 110₁, 110₂, 110₃, 111₁, 111₂, 111₃ de mesure de la tension à ses bornes. De préférence, chacun de ces moyens échantillonne périodiquement la tension aux bornes du module auquel il est associé. Dans la suite, on désignera par Vₘₚₚ la tension aux bornes de l'un de ces moyens, dans le cas d'un fonctionnement normal, sans arc électrique (ni dans le module correspondant, ni dans un autre). Selon un exemple de réalisation, chaque module est muni d'une carte comportant des moyens interrupteurs tels que ceux décrits dans les demandes FR 2 965 626, FR 2 965 627 ou FR 2 965 628 et des moyens de mesure de tension. C'est cette carte qui est désignée, en figure 1D, par les références 110₁ - 110₃, 111₁ - 111₃. Un exemple de tels moyens interrupteurs est schématisé en figure 1E, où ces moyens sont connectés entre les bornes C et D de sortie d'un module PV. Dans la cadre de la présente invention, on se limitera de préférence à la configuration illustrée sur cette figure 1E, dans laquelle l'interrupteur S1 est fermé, tandis que l'interrupteur S2 est en position ouverte. On retrouve cette même configuration en figure 1D, les différents modules 100₁ - 100₃, 101₁ - 101₃ d'une même chaîne étant ainsi reliés en série.

Dans les 2 structures représentées en figures 1C et 1D, un élément 10 impose une charge capacitive à la sortie de l'installation, ou encore présente un comportement capacitif pour les modules, tel qu'un convertisseur ou un onduleur ou une batterie.

Cet élément 10 est relié au réseau électrique 12.

Pour chaque chaîne, il y a 2 bornes libres d'extrémités, non reliées à un autre détecteur en série de la même chaîne. Comme illustré en figure 1D, les différentes bornes libres des différentes chaînes peuvent être combinées dans des moyens 200, de type boîtier de combinaison (« combiner box »), de manière à raccorder en parallèle les chaînes de détecteurs qui sont, eux -mêmes, raccordés en série dans une même chaîne.

Un interrupteur/sectionneur 210 peut être disposé en sortie des moyens 200, en amont des moyens 10 (par exemple un convertisseur ou un onduleur ou une batterie). La référence 202 désigne une unité centrale, qui va permettre de mémoriser les données de mesure de tension provenant des différents moyens de mesure de tension 110₁ - 110₃ ou 111₁ - 111₃. Elle peut permettre de, ou être programmée pour, traiter ces données de mesure de tension.

La tension et le courant débités par les modules photovoltaïques dépendent de plusieurs paramètres (ensoleillement, température), et peuvent varier d'une façon importante.

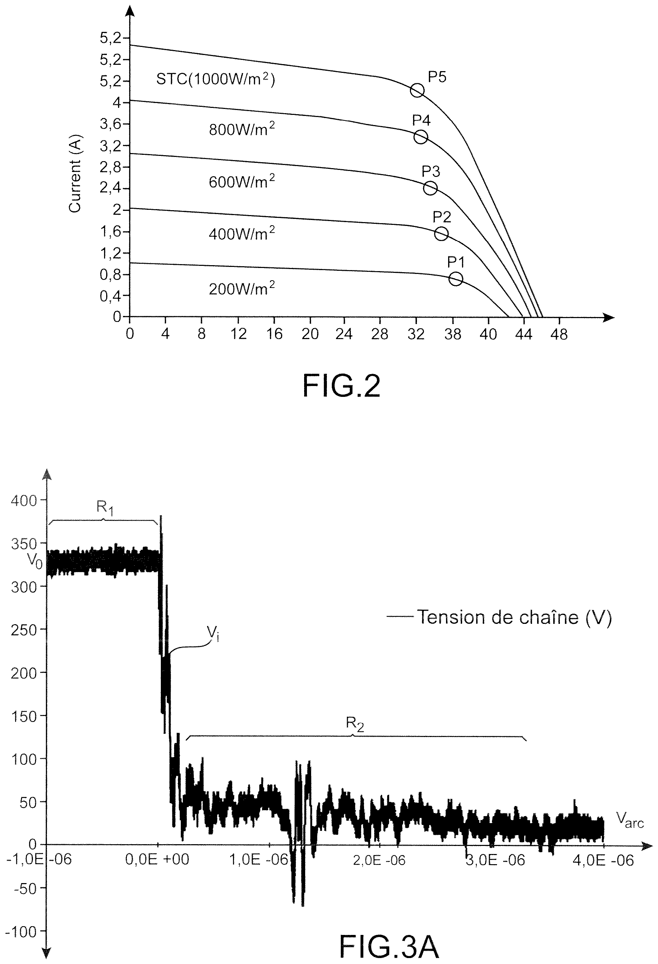

La figure 2 montre des courbes caractéristiques d'un module photovoltaïque en fonction de l'éclairement reçu (de 200 à 1000W/cm2). Le courant débité par le module varie fortement en fonction de cet éclairement (proportionnellement dans une première approximation). Les points de fonctionnement P1, P2,...Pk sur les courbes de la figure 2 sont les points où le module délivre le maximum de puissance pour un éclairement donné.

Afin d'optimiser la production d'énergie, le convertisseur ou l'onduleur 10 impose une tension de fonctionnement aux modules de façon à ce que ces derniers produisent le maximum de puissance (cette fonction est appelée : MPPT = « maximum power point tracking »).

Un arc électrique parallèle peut se produire aux bornes d'une ou plusieurs des chaines 100, 101 (par exemple un arc parallèle peut se développer entre les points A et B de la figure 1C), ou aux bornes d'un des modules 100₁ - 100₃, 101₁ - 101₃ d'une des chaines (autrement dit : entre des cellules d'un module).

Un arc électrique série peut se produire entre une extrémité d'une quelconque des chaines et les moyens convertisseurs 10, ou dans une chaîne de modules ou dans un module PV.

On rappelle qu'on entend par arc « parallèle » un arc se produisant entre des points qui sont à des potentiels différents, tandis qu'un arc « série » se produit entre des points ou des bornes qui sont à des potentiels identiques.

Grâce à leur capacité d'entrée, ou à leur charge d'entrée de nature capacitive, les moyens 10 permettent, pendant la durée d'établissement d'un arc, de maintenir une tension stable en sortie des chaînes de modules PV. Comme déjà indiqué ci-dessus, en variante, on peut prévoir un onduleur, ou une charge capacitive telle qu'un convertisseur ou une batterie, qui permettra le même effet de stabilisation.

Lorsqu'en un arc se produit, la valeur finale, minimale, de la tension d'arc V_{arc} est d'environ 10V. Elle est liée aux caractéristiques physiques d'un arc électrique. En effet, comme d'ailleurs déjà expliqué dans le document FR 2912 848, un arc électrique peut être décomposé en 3 zones :
- 1 zone d'interface électrode/air ;
- 1 zone de plasma ;
- 1 zone d'interface air/électrode.

Les deux zones d'interface se présentent comme une jonction PN d'une diode, à savoir une jonction entre un matériau conducteur et un isolant.

Cette jonction présente donc un potentiel fixe qui est directement lié aux potentiels des matériaux en présence. Celui de l'air ne varie pas, en revanche celui de l'électrode peut varier suivant que l'électrode est en cuivre, ou en aluminium, ou en argent... Ce potentiel est donc présent à chaque interface et est caractéristique de l'arc. Il apparaît dès l'amorçage (avant établissement du plasma) et sa valeur, V_{arc} mesurée aux bornes de l'arc, est comprise entre 10V et 20V ou même 30V.

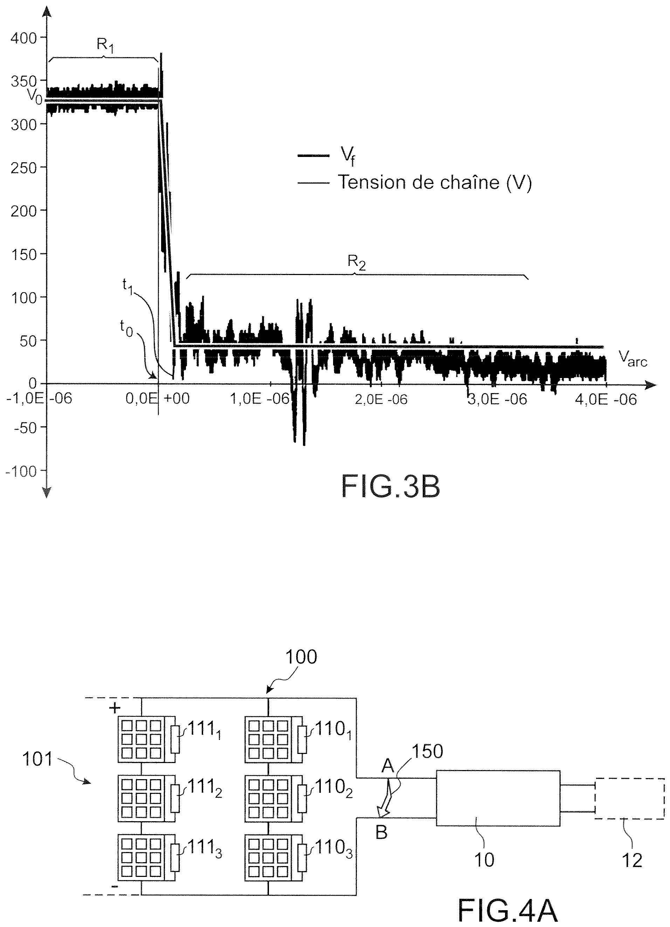

Dans le cas d'un arc électrique parallèle l'évolution de la tension instantanée Vᵢₚ aux bornes de l'arc peut prendre la forme représentée en figure 3A. Est également représentée, en figure 3B, la tension V_{fp}, qui résulte d'un filtrage de la tension instantanée Vᵢₚ. Une variation de tension, due à l'apparition de l'arc, se produit entre une 1^{ère} zone de stabilité en tension (zone R₁ sur les figures 3A et 3B), à une valeur de tension V₀ₚ dite valeur initiale, et une 2^{ème} zone de stabilité en tension (zone R₂ sur les figures 3A et 3B), à la valeur V_{arc}, valeur finale de la tension d'arc. Cette 2^{ème} zone de stabilité a une durée d'au moins quelques µs, par exemple au moins 5 µs ou au moins 10 µs. Les oscillations observées dans les zones R₁ et R₂ sont principalement dues à la mesure.

Globalement, on observe une chute très nette de la tension mesurée.

Malgré des oscillations de tension variables, observées au début du front de la tension instantanée Vᵢₚ, la signature de l'arc se caractérise, entre la 1^{ère} zone de stabilité en tension et la 2^{ème} zone de stabilité en tension, par une évolution négative ΔV (= V_{arc} - V₀) de la tension Vᵢₚ (mais, également, de V_{fp}, puisque celle-ci est directement déduite de Vᵢₚ, par lissage) d'une valeur absolue comprise - dans le cas d'un arc se produisant entre les points A et B - entre 1500 V et 10 V. Dans l'exemple des figures 3A et 3B, la valeur absolue de ΔV est d'environ 350 V.

Pour un même éclairement, l'amplitude de l'évolution de la tension instantanée dépend de la position ou de la localisation de l'arc parallèle dans le système : elle sera différente si il se produit entre les bornes A et B (ces bornes sont représentées en figures 1A - 1C) ou, comme on le verra plus loin, aux bornes d'un des modules d'une chaine.

Un autre paramètre d'un arc électrique parallèle apparaissant dans un système photovoltaïque est le temps de descente ΔT de la variation, à la baisse, de la signature de l'arc électrique (de t₀ à t₁ sur la courbe II de la figure 3B, t₀ identifiant l'instant considéré comme le début de l'arc, t₁ identifiant l'instant considéré comme la fin de l'arc). ΔT est mesuré entre la valeur initiale V₀ de la tension et la valeur finale V_{arc}, avec une marge d'erreur, par exemple + 10%, cette marge d'erreur étant due au bruit sur la forme d'onde. Ce temps de descente est lié aux caractéristiques physiques des modules photovoltaïques et à leur comportement dynamique. Un module photovoltaïque représente une certaine valeur de capacité parasite variable. Il possède donc un temps de réponse à un échelon de tension qui lui est caractéristique. Ce temps varie peu selon les différentes technologies de modules photovoltaïques. Ce temps de descente ΔT peut être compris entre 0.01 µs et 10 µs.

Ces spécificités permettent d'identifier ou de qualifier, entre 2 zones de stabilité de la tension, la signature d'un arc électrique parallèle, dans un système PV.

Dans la suite, qu'il s'agisse du cas d'un arc parallèle ou d'un arc série, on utilise les mesures de tension réalisées l'aide des moyens 110₁ - 110₃ ou 111₁ - 111₃. On appellera variation de tension la différence V_{finale} - Vᵢₙᵢₜᵢₐₗₑ entre la tension finale et la tension initiale mesurées par ces moyens.

On considère d'abord le cas d'un arc électrique parallèle se produisant entre les bornes A et B de la figure 1C.

Ce cas est illustré en figure 4A, où l'arc est désigné par la référence 150.

Conformément à ce qui a été expliqué ci-dessus, on rappelle que, entre les bornes A et B elles - mêmes, la tension passe d'une valeur de V_{MPP} (différence de tension entre A et B), par exemple d'environ 350V, à une valeur comprise entre 10 et 30V (= V_{arc}) en un temps t_{arc} compris entre 0.01 µs et 10 µs.

La tension mesurée par chacun des moyens 110₁ - 110₃ ou 111₁ - 111₃ de mesure de la tension évolue d'une valeur initiale à une valeur finale avec une pente négative. Plus précisément, la tension aux bornes de chacun de ces détecteurs passera d'une valeur initiale Vₘₚₚ à une valeur finale V_{arc}/n_{mod}, où V_{arc} a déjà été définie ci-dessus et où n_{mod} est le nombre de modules PV dans la chaîne dans laquelle le détecteur est situé. La variation de tension, au sens déjà indiqué ci-dessus, est donc de V_{arc}/n_{mod} - Vₘₚₚ.

Cette variation aura une valeur absolue d'environ quelques dizaines ou centaines de mV, par exemple comprise entre 0,01 V et 1 V. Le temps de descente est quant à lui sensiblement égal à t_{arc}, compris dans les limites indiquées ci-dessus (0,01 µs-10 µs).

L'identification de la variation de tension V_{arc}/n_{mod} - Vₘₚₚ aux bornes de chacun des détecteurs de chacune des différentes chaînes permet d'estimer qu'un arc électrique parallèle s'est produit entre les bornes A et B.

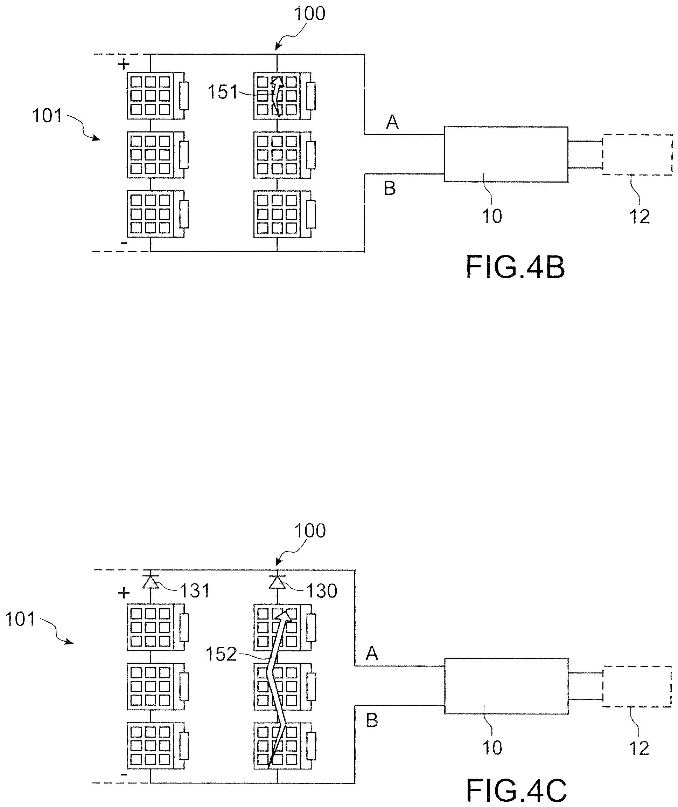

On considère maintenant le cas d'un arc électrique parallèle qui se produit entre les bornes d'un des modules 100₁ - 100₃, 101₁ - 101₃ d'une des chaînes 100, 101,..... Ce cas est illustré en figure 4B, où l'arc est désigné par la référence 151. Dans ce cas, la tension mesurée par le détecteur associé au module entre les bornes duquel l'arc se produit évolue avec une pente négative, passant de Vₘₚₚ à V_{arc} avec un temps de descente qui peut être compris entre 0.01 µs et 10 µs.

Mesurée aux bornes d'un autre module de la même chaine, différent de celui aux bornes duquel l'arc se produit, la tension varie cette fois d'une valeur initiale Vₘₚₚ à une valeur finale Vₘₚₚ + (Vₘₚₚ - V_{arc})/(n_{mod}- 1), avec une pente positive. En effet, la variation de tension aux bornes du module où s'est produit l'arc se répartit sur les autres modules de la même chaîne, car la tension aux bornes de l'ensemble de la chaîne ne varie pas.

Par contre, les détecteurs associés aux modules d'une autre chaîne que celle qui contient le module aux bornes duquel l'arc se produit ne pourront identifier aucune variation de tension qui serait liée à cet arc.

L'identification d'une telle variation de tension à pente négative V_{arc} - Vₘₚₚ aux bornes de l'un des modules d'une chaîne, alors que les autres détecteurs des autres modules de la même chaîne détectent une variation de tension à pente positive, permet d'estimer qu'un arc électrique parallèle s'est produit entre les bornes du module pour lequel la variation de tension à pente négative a été détectée.

Dans certains cas, une diode 130, 131 peut être disposée en tête de chaque chaîne, afin d'éviter tout retour de courant d'une chaîne vers l'autre. Cette configuration est représentée en figure 4C. C'est en particulier le cas s'il y a plus de 3 chaînes. La différence de potentiel rajoutée par une diode dans une telle chaîne est négligeable par rapport aux tensions mises en jeu dans la chaîne. Mais, dans ce cas, un arc 152 peut se produire entre l'anode d'une des diodes 130, 131 et les moyens 10.

La tension mesurée par chacun des moyens 110₁ - 110₃, de mesure de tension dans la chaîne dans laquelle l'arc se produit évolue alors d'une valeur initiale à une valeur finale avec une pente négative. Plus précisément, la tension aux bornes de chacun de ces détecteurs passera d'une valeur initiale Vₘₚₚ à une valeur finale V_{arc}/n_{mod}, où n_{mod} est le nombre de modules PV dans la chaîne dans laquelle le détecteur est situé, la variation de tension étant donc de V_{arc}/n_{mod} - Vₘₚₚ.

Par contre, aucune variation de tension n'est mesurée par les moyens 111₁ - 111₃ d'une autre chaîne que celle dans laquelle l'arc se produit.

Dans les divers cas d'arcs parallèles envisagés ci-dessus, la nature de l'arc peut être constatée ou confirmée par l'amplitude de la variation de tension mesurée aux bornes d'un ou plusieurs des modules, d'une part, et par la valeur du temps de montée ou de descente, qui peut être sensiblement compris entre 0,01 µs et 10 µs.

Par exemple, dans le premier cas d'arc électrique parallèle envisagé ci-dessus, l'amplitude de la variation négative de tension vue aux bornes d'un module est de V_{arc}/n_{mod} - Vₘₚₚ pour un temps de descente t_{arc} qui peut être sensiblement compris entre 0,01 µs et 10 µs.

De manière similaire ou équivalente, on peut identifier un arc :
- par la valeur du temps de montée ou de descente et par la pente de la variation de tension lors de son évolution temporelle ;
- ou par la variation de tension ΔV et par la pente de la variation de tension lors de son évolution temporelle.

Dans le premier cas d'arcs électriques parallèles envisagés, on pourra donc, de manière similaire ou équivalente, identifier l'arc :
- par la valeur du temps de descente t_{arc} et par la pente (V_{arc}/n_{mod} - Vₘₚₚ₎/t_{arc} de la variation de tension mesurée par chacun des détecteurs (compte tenu des valeurs minimum et maximum de t_{arc} cette pente sera comprise entre 10² (Vₘₚₚ - V_{arc}/n_{mod)}V/ µs et 10⁻¹ (Vₘₚₚ - V_{arc}/n_{mod)} V/ µs) ;
- ou par la variation de tension ΔV et par la pente (Vₘₚₚ - V_{arc}/n_{mod})/t_{arc} de la variation de tension mesurée par chacun des détecteurs, qui sera comprise dans les limites qui viennent d'être indiquées ci-dessus.

La même caractérisation s'applique aux deux autres cas d'un arc parallèle qui ont été exposés ci-dessus.

Dans le 2^{ème} cas d'arc électrique parallèle envisagé ci-dessus, l'amplitude de la variation négative de tension aux bornes du module aux bornes duquel se produit est de V_{arc} - Vₘₚₚ pour un temps de descente t_{arc} qui peut être sensiblement compris entre 0,01 µs et 10 µs.

On pourra aussi identifier l'arc :
- par la valeur du temps de descente t_{arc} et par la pente (V_{arc} - Vₘₚₚ)/ t_{arc} de la variation de tension mesurée par chacun des détecteurs (compte tenu des valeurs minimum et maximum de t_{arc} cette pente sera comprise entre 10² (V_{arc} - Vₘₚₚ)V/ µs et 10⁻¹ (V_{arc} - Vₘₚₚ)V/ µs) ;
- ou par la variation de tension ΔV et par la pente (V_{arc} - Vₘₚₚ)/ t_{arc} de la variation de tension mesurée par chacun des détecteurs, qui sera comprise dans les limites qui viennent d'être indiquées ci-dessus.

Toujours dans ce 2^{ème} cas, l'amplitude de la variation positive de tension aux bornes des modules autres que celui aux bornes duquel l'arc se produit est de (Vₘₚₚ - V_{arc})/(n_{mod} - 1) pour un temps de montée t_{arc} qui peut être sensiblement compris entre 0,01 µs et 10 µs.

On pourra aussi identifier l'arc :
- par la valeur du temps de montée t_{arc} et par la pente (Vₘₚₚ - V_{arc})/(n_{mod} - 1)/ t_{arc} de la variation de tension mesurée pour chacun de ces autres modules (compte tenu des valeurs minimum et maximum de t_{arc} cette pente sera comprise entre 10² (Vₘₚₚ - V_{arc})/(n_{mod}- 1) V/ µs et 10⁻¹(Vₘₚₚ - V_{arc})/(n_{mod}- 1)V/ µs) ;
- ou par la variation de tension ΔV et par la pente (Vₘₚₚ - V_{arc})/(n_{mod} - 1)/ t_{arc} de la variation de tension mesurée par chacun des détecteurs, qui sera comprise dans les limites qui viennent d'être indiquées ci-dessus.

Dans le 3^{ème} cas d'arc électrique parallèle envisagé ci-dessus, l'amplitude de la variation négative de tension aux bornes de chacun des modules de la chaîne est de V_{arc}/n_{mod} - Vₘₚₚ pour un temps de descente t_{arc} qui peut être sensiblement compris entre 0,01 µs et 10 µs.

On pourra aussi identifier l'arc :
- par la valeur du temps de descente t_{arc} et par la pente (V_{arc}/n_{mod} - Vₘₚₚ)/ t_{arc} de la variation de tension mesurée par chacun des détecteurs de la chaîne concernée (compte tenu des valeurs minimum et maximum de t_{arc} cette pente sera comprise entre 10² (V_{arc}/n_{mod} - Vₘₚₚ)V/ µs et 10⁻¹ (V_{arc}/n_{mod} - Vₘₚₚ)V/ µs) ;
- ou par la variation de tension ΔV et par la pente (V_{arc}/n_{mod} - Vₘₚₚ)/ t_{arc} de la variation de tension mesurée par chacun des détecteurs de la chaîne concernée, qui sera comprise dans les limites qui viennent d'être indiquées ci-dessus.

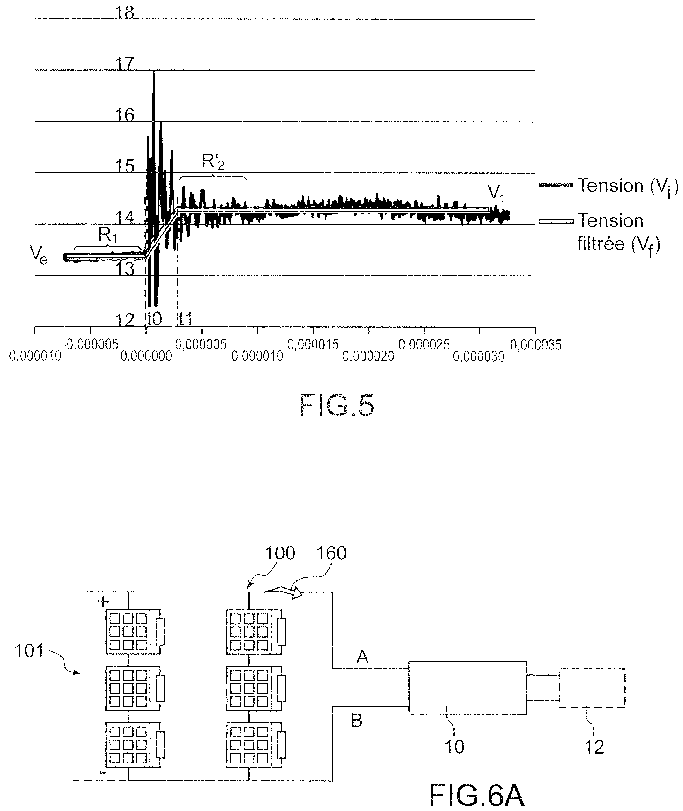

La signature caractéristique d'un arc électrique de type « série » est sensiblement différente de celle d'un arc parallèle, puisqu'elle comporte une évolution de la tension à la hausse, qui peut prendre la forme représentée en figure 5. Est également représentée sur cette figure la tension V_{fs}, qui résulte d'un filtrage de la tension instantanée Vᵢₛ. On note que les variations de tension se produisent entre une 1^{ère} zone de stabilité en tension (zone R'₁ sur la figure 5), à une valeur de tension V₀ₛ dite valeur initiale, et une 2^{ème} zone de stabilité en tension (zone R'₂ sur la figure 5), à une valeur V₀ₛ + V_{arc} de tension dite valeur finale, avec une pente positive. Cette 2^{ème} zone de stabilité a une durée d'au moins quelques µs, par exemple au moins 5 µs ou au moins 10 µs.

Globalement, on observe un accroissement de la tension mesurée, de V₀ₛ à V₁ₛ = V₀ₛ + V_{arc}.

Là encore, un autre paramètre d'un arc électrique série apparaissant dans un système photovoltaïque est le temps de montée ΔT du front de tension (de t₀ à t₁ sur la courbe II de la figure 5), qui est mesuré entre la valeur initiale de la tension et sa valeur finale, avec une marge d'erreur, par exemple + 10%, cette marge d'erreur étant due au bruit sur la forme d'onde. Ce temps de montée est lié aux caractéristiques physiques des modules photovoltaïques et à leur comportement dynamique. Comme déjà expliqué ci-dessus, un module PV représente une certaine valeur de capacité parasite ou équivalente variable, donc un temps de réponse à un échelon de tension qui lui est caractéristique, mais ce temps varie peu selon les différentes technologies de modules PV et est compris entre 0,5 µs et 5 µs.

Ces spécificités permettent de caractériser ou de qualifier, entre 2 zones de stabilité de la tension, la signature d'un arc électrique série, caractéristique du milieu d'un système PV.

Les gammes de temps de montée et de descente indiquées ci-dessus et concernant les situations dans lesquelles un arc parallèle se développe et celles dans lesquelles un arc série se développe, sont assez voisines, respectivement 0,01 µs-10 µs et 0,5 µs-5 µs. On pourra éventuellement, par souci de simplification, considérer un même intervalle, par exemple 0,01 µs-10 µs, pour les deux cas.

On va maintenant expliquer comment il est également possible d'estimer ou de caractériser l'existence d'un arc série, et d'en estimer la position, en fonction des données de variations de tensions fournies par les détecteurs 110₁- 110₃, ou 111₁ - 111₃.

On considère d'abord le cas d'un arc électrique série entre la sortie d'une quelconque des chaines et les moyens 10. Ce cas est illustré en figure 6A, ou l'arc est désigné par la référence 160. Dans ce cas, la tension mesurée par chacun des moyens 110₁ - 110₃, ou 111₁ - 111₃ de mesure de la tension évolue alors d'une valeur initiale à une valeur finale avec une pente positive. Plus précisément, la tension aux bornes de chacun de ces détecteurs passera d'une valeur initiale Vₘₚₚ à une valeur finale Vₘₚₚ + V_{arc}/n_{mod}, où n_{mod} est le nombre de modules PV dans la chaîne dans laquelle le détecteur est situé, la variation de tension étant donc de V_{arc}/n_{mod}.

L'identification d'une telle variation de tension aux bornes de chacun des détecteurs permet d'estimer qu'un arc électrique série, localisé comme indiqué ci-dessus, s'est produit.

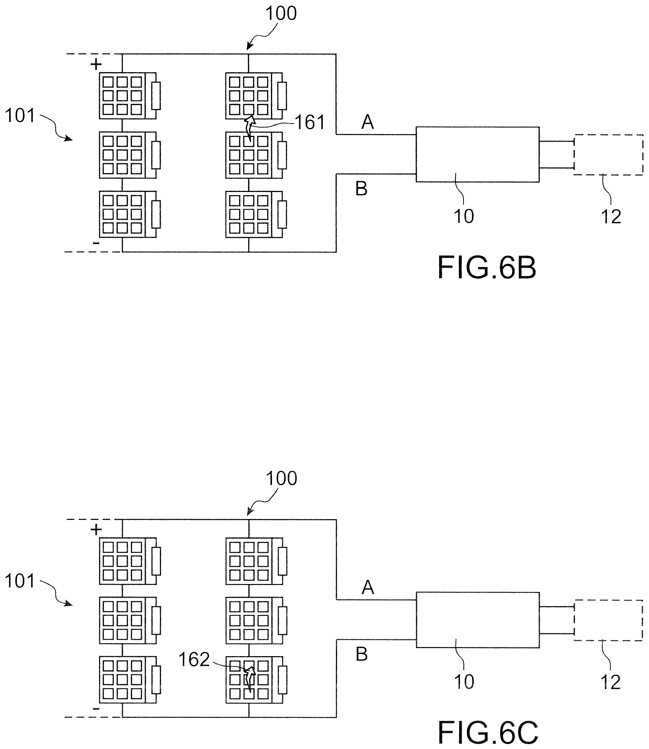

On considère maintenant le cas d'un arc électrique série qui se produit à l'intérieur d'une seule des chaînes 100, 101 (quelle que soit la position en dehors de l'un quelconque des modules de cette même chaîne). Ce cas est celui illustré en figure 6B, où l'arc est désigné par la référence 161. Dans ce cas, la tension mesurée par chaque détecteur associé à un module quelconque de cette chaîne évolue positivement, passant de Vₘₚₚ à Vₘₚₚ + V_{arc}/n_{mod}.

Par contre, les détecteurs associés aux modules d'une autre chaîne ne pourront identifier aucune variation de tension.

L'identification de la variation de tension V_{arc}/n_{mod} aux bornes de chacun des détecteurs d'une même chaîne, alors que les détecteurs associés aux modules d'une autre chaîne ne détectent aucune variation de tension, permet d'estimer qu'un arc électrique série s'est produit à l'intérieur de ladite chaîne seulement, mais pas à l'intérieur d'un des modules de cette même chaîne.

Dans les 2 cas de détection d'un arc série qui viennent d'être décrits, on identifie, sur la mesure de la tension, une signature caractéristique d'un arc électrique, qui se traduit, aux bornes des modules d'une chaîne ou de plusieurs chaînes, par une hausse rapide de la tension, avec un temps de montée ΔT compris entre 0,5 µs et 5 µs.

Les variations de tension se produisent entre une 1^{ère} zone de stabilité en tension, à une valeur de tension Vₘₚₚ dite valeur initiale, et une 2^{ème} zone de stabilité en tension, à une valeur V₁ (Vₘₚₚ + V_{arc}/n_{mod}) de tension dite valeur finale. Cette 2^{ème} zone de stabilité a une durée d'au moins quelques µs, par exemple au moins 5 µs ou au moins 10 µs.

A la suite du front de montée, la tension s'établi à la valeur finale V₁ du front de tension égale à environ Vₘₚₚ + V_{arc}/n_{mod}, et reste sensiblement à cette valeur pendant la durée minimale indiquée ci-dessus.

Enfin, le cas d'un arc électrique série qui se produit à l'intérieur d'un module d'une des chaînes 100, 101,...., ou encore entre des cellules d'un tel module, est illustré en figure 6C, ou l'arc est désigné par la référence 162.

La tension mesurée par le détecteur associé au module à l'intérieur duquel l'arc se produit, évolue avec une pente négative, passant de Vₘₚₚ à Vₘₚₚ - V_{arc}x(1/n_{mod}- 1).

Mesurée aux bornes d'un autre module de la même chaine, différent de celui à l'intérieur duquel l'arc série se produit, la tension varie avec une pente positive et passe d'une valeur initiale de Vₘₚₚ à Vₘₚₚ + V_{arc}/n_{mod}. En effet, la variation de tension aux bornes du module à l'intérieur duquel s'est produit l'arc se répartit sur les autres modules de la même chaîne, car la tension aux bornes de l'ensemble de la chaîne ne varie pas.

Par contre, les détecteurs associés aux modules d'une autre chaîne ne pourront identifier aucune variation de tension associée à cet arc particulier.

L'identification d'une variation de tension négative aux bornes de l'un des détecteurs d'une chaîne, avec une valeur finale de Vₘₚₚ - V_{arc}x(1/n_{mod} - 1), alors que les autres détecteurs de la même chaîne détectent une variation de tension positive permet de conclure à l'existence d'un arc électrique série à l'intérieur du module pour lequel la variation de tension négative a été détectée.

Dans les divers cas d'arcs de type « série » envisagés ci-dessus, la nature de l'arc peut être constatée ou confirmée par l'amplitude de la variation de tension, d'une part, et par la valeur du temps de montée ou de descente, qui peut être sensiblement compris entre 0,5 µs et 5 µs.

Par exemple, dans les 1ers premier cas d'arc série envisagés ci-dessus, l'amplitude ΔV de la variation positive de tension vue aux bornes de chacun des modules d'une ou plusieurs chaînes est de V_{arc}/n_{mod} pour un temps de montée t_{arc} qui peut être sensiblement compris entre 0,5 µs et 5 µs.

De manière similaire ou équivalente, on peut identifier un arc :
- par la valeur du temps de montée ou de descente et par la pente de la variation de tension lors de son évolution temporelle ;
- par la variation de tension ΔV et par la pente de la variation de tension lors de son évolution temporelle.

Dans le premier cas d'arcs électriques de type série envisagé, on pourra donc, de manière similaire ou équivalente, identifier l'arc :
- par la valeur du temps de montée t_{arc} et par la pente V_{arc}/n_{mod} /t_{arc} de la variation de tension aux bornes des modules de la chaîne concernée ou des chaînes concernées (compte tenu des valeurs minimum et maximum de t_{arc} cette pente sera comprise entre 2x (V_{arc}/n_{mod}) V/ µs et 0, 2 (V_{arc}/n_{mod}) V/ µs) ;
- par la variation de tension ΔV et par la pente (V_{arc}/n_{mod})/t_{arc} de la variation de tension, qui sera comprise dans les limites qui viennent d'être indiquées ci-dessus.

La même caractérisation s'applique au 3^{ème} cas d'arc série qui a été exposé ci-dessus.

On comprend des explications ci-dessus que la nature, parallèle ou série, d'un arc, peut être estimée en fonction du nombre de détecteurs qui détectent effectivement une variation de tension aux bornes des modules correspondants et du signe de cette variation. On peut également, à partir des mêmes critères, estimer la position d'un arc dans un ensemble photovoltaïque, l'arc pouvant être localisé comme sur l'une des figures 4A-4C et 6A-6C.

En outre, comme déjà expliqué ci-dessus, un critère pour estimer si un arc est bien présent peut être :
- la valeur finale de la tension, après variation, et/ou l'amplitude de cette variation, et la durée (temps de montée ou temps de descente) pendant laquelle cette variation se produit ou le taux moyen ou la pente de cette variation ;
- ou encore cette durée pendant laquelle cette variation se produit et ce taux moyen ou cette pente de cette variation.

Le terme « estimer » doit être compris comme exprimant un diagnostic possible, mais avec une marge d'erreur (par exemple ± 10% ou même 20%), ou encore comme exprimant une certaine probabilité.

Ainsi, une variation positive de la tension se produisant aux bornes de tous les modules de toutes les chaînes sera probablement l'indication de l'existence d'un arc série, en tête de l'installation photovoltaïque (figure 6A).

Une variation positive de la tension se produisant aux bornes de tous les modules d'une même chaîne, mais pas aux bornes des modules d'une quelconque autre chaîne, pourra être vue comme l'indication de l'existence d'un arc série dans cette chaine (dans les connexions entre modules ou en amont des modules) (figure 6B).

Pour une variation négative de la tension, aux bornes d'un seul module d'une même chaîne, alors que, pour les autres modules de la même chaîne, la variation de tension est positive, on pourra avoir :
- un arc parallèle aux bornes du module à variation négative de la tension, si la valeur finale de celle-ci est égale à la tension V_{arc} (cas de la figure 4B) ;
- ou un arc série, situé à l'intérieur du module à variation négative de la tension, si la valeur finale de celle-ci est égale à la tension Vₘₚₚ - V_{arc}x(1/n_{mod} - 1) (cas de la figure 6C).

Une variation négative de la tension se produisant aux bornes de tous les modules de toutes les chaînes sera probablement l'indication de l'existence d'un arc parallèle, en tête de l'installation photovoltaïque (comme en figure 4A).

Enfin, dans le cas de la présence d'une diode disposée en tête de chaque chaîne, une variation négative de la tension se produisant aux bornes de tous les modules d'une même chaîne, mais pas aux bornes des modules d'une quelconque autre chaîne, sera probablement l'indication de l'existence d'un arc parallèle, en tête de l'installation photovoltaïque (comme en figure 4C).

Dans tous les cas considérés ci-dessus, qu'il s'agisse d'une variation positive ou négative, la durée de la variation (c'est-à-dire le temps de monte ou le temps de descente) est dans l'une des gammes indiquées ci-dessus, et la variation se produit entre une 1^{ère} zone de stabilité de la tension et une 2^{ème} zone de stabilité de la tension, au sens déjà expliqué ci-dessus.

En fonction du signe et des valeurs de variation de tension constatées, un opérateur et/ou des moyens 202, 77 (figures 1D, 9-11) de traitement de données, spécialement programmés à cet effet pourra/pourront estimer la nature d'un arc et/ou sa position ou sa localisation, par exemple par comparaison avec des valeurs de référence.

Éventuellement, ils sont aptes à, ou programmés pour, également, qualifier ou confirmer l'existence d'un arc, selon l'un des critères décrits ci-dessus. Ces moyens 202, 77 peuvent par exemple comporter un microprocesseur ou un ordinateur.

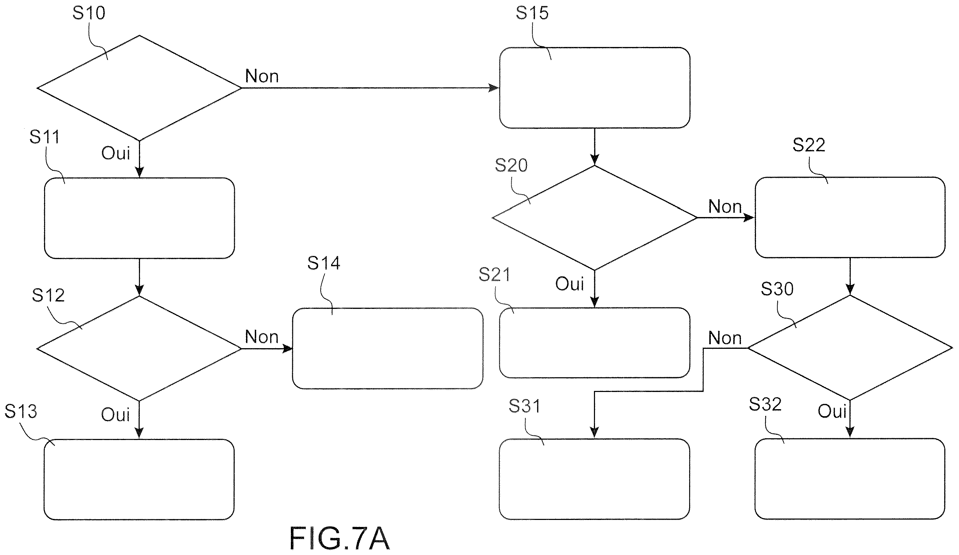

On a représenté, en figure 7A, un autre exemple de procédé pouvant être mis en oeuvre dans le cadre de la présente invention, par exemple à l'aide des moyens 202, 77 évoqués ci-dessus.

Chacun des détecteurs échantillonne périodiquement la tension aux bornes du module auquel il est associé.

On teste d'abord (étape S10) si tous les capteurs fournissent un signal de déclenchement.

Si oui, on peut en déduire (étape S11) qu'il s'est vraisemblablement produit un arc en série en tête de l'installation ou un arc en parallèle aux bornes d'une ou plusieurs des chaines 100, 101, c'est-à-dire entre les points A et B de la figure 1B.

Il est ensuite possible (étape S12) de tester le signe de dV/dt :
- Si dV/dt est positif alors l'arc est probablement de type « série » (S13), en tête de l'installation;
- Si il est négatif, alors il s'agit plus probablement d'un arc « parallèle » (S14), entre les points A et B de la figure 1B.

Dans le cas où tous les capteurs n'ont pas fourni un signal de déclenchement (S15), alors l'une des trois hypothèses suivantes est possible :
- l'arc est de type « série » sur une des chaines ;
- l'arc est de type « série » dans un module ;
- l'arc est de type « parallèle », aux bornes d'un module.

Pour estimer dans lequel de ces trois cas on se trouve, on peut tester (étape S20) si tous les capteurs d'une même chaîne ont une variation de tension dV/dT positive.

Si c'est le cas, alors on peut en déduire que l'on est en présence d'un arc de type « série » sur la chaîne concernée (étape S21).

Si ce n'est pas le cas, alors on peut être dans le cas d'un arc de type « série » dans un module, ou d'un arc « parallèle » aux bornes d'un module (S22).

Le procédé pourrait se limiter aux étapes ci-dessus, mais des étapes supplémentaires peuvent être réalisées pour déterminer lequel des deux cas de l'étape précédente S22 est le plus susceptible de s'être produits.

Pour cela on cherche à déterminer si la tension finale est égale à la tension d'arc sur le module concerné, avec une variation dV/dT inférieur à zéro (étape S30).

Si la réponse est négative, alors il s'agit probablement d'un arc de type « série » aux bornes d'un module (étape S31).

Si la réponse est positive, il s'agit probablement d'un arc de type « parallèle» dans un module (étape S32).

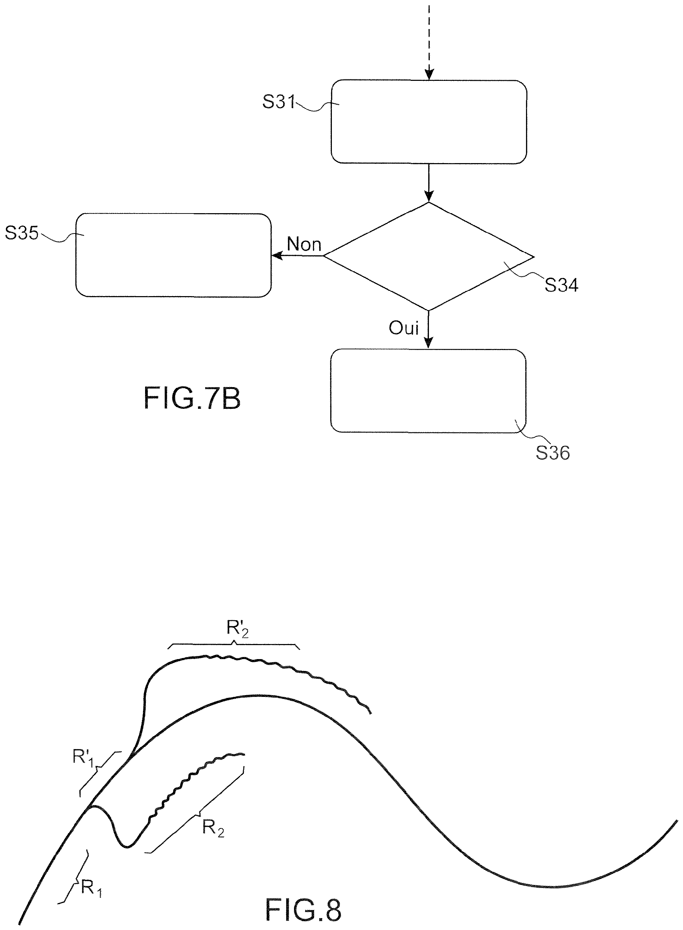

Une variante de ce procédé, illustrée en figure 7B, concerne le cas d'un système dans lequel une diode 130, 131 est présente en tête de chaque chaîne. Dans ce cas, une réponse négative à la question de l'étape S30 signifie que l'on peut être dans le cas d'un arc de type « série » aux bornes dans un module ou d'un arc parallèle entre l'anode de la diode positionnée en tête de la chaîne concernée et les moyens 10. Pour déterminer dans lequel de ces deux cas on se trouve, on cherche à déterminer si la tension finale est égale à la tension V_{arc}/n_{mod} aux bornes de chacun des modules de la chaîne concernée (étape S34).

Si la réponse est négative, alors il s'agit probablement d'un arc de type « série » aux bornes d'un module (étape S35).

Si la réponse est positive, il s'agit probablement d'un arc de type « parallèle» entre l'anode de la diode positionnée en tête de la chaîne concernée et les moyens 10 (étape S36).

L'invention a été décrite ci-dessus dans le cas d'un courant continu, les moyens 10 permettant de maintenir une tension stable en sortie des chaînes de modules PV. Cependant, l'onduleur 10 peut induire des perturbations, auquel cas il en résulte une tension variable, sinusoïdale, à une fréquence par exemple égale à 100 Hz.

L'enseignement de la présente invention reste applicable à ce type de situation.

Une partie du signal sinusoïdal correspondant est représenté en figure 8.

Une variation de tension décrite ci-dessus se retrouve sur un tel signal, entre des portions du signal qui présentent des pentes sensiblement stables.

Ainsi, dans le cas d'un arc parallèle, la variation qui a été décrite ci-dessus en liaison avec les figures 3A et 3B se retrouve ici entre une portion R₁ du signal qui présente une pente positive sensiblement constante et une autre portion R₂ du signal qui présente elle aussi une pente positive sensiblement constante. On ferait un raisonnement similaire si l'arc se produisait dans une portion décroissante du signal sinusoïdal, la variation de tension se produisant alors entre une portion du signal qui présente une pente négative sensiblement constante et une autre portion du signal qui présente elle aussi une pente négative sensiblement constante.

Dans le cas d'un arc de type « série », la variations qui a été décrite ci-dessus en liaison avec la figure 5 se retrouve entre une portion R'₁ du signal qui présente une pente positive sensiblement constante et une autre portion R'₂ du signal qui présente elle aussi une pente positive sensiblement constante. On ferait un raisonnement similaire si l'arc se produisait dans une portion décroissante du signal sinusoïdal, la variation de tension se produisant alors entre une portion du signal qui présente une pente négative sensiblement constante et une autre portion du signal qui présente elle aussi une pente négative sensiblement constante.

Dans ces divers cas d'une tension variable, sinusoïdale, les variations de tension mesurées par les moyens 110₁ - 110₃ ou 111₁- 111₃ présentent les mêmes caractéristiques (amplitude de variation, temps de montée ou de descente) que celles qui ont déjà été exposées ci-dessus dans les divers cas.

L'invention peut en outre également s'appliquer au cas d'un système fonctionnant en courant alternatif.

Des exemples de réalisation d'un dispositif pour détecter un arc mettent en oeuvre des moyens techniques permettant de faire l'acquisition du signal et de discriminer une signature du type décrite ci-dessus.

Pour cela différentes solutions techniques sont possibles.

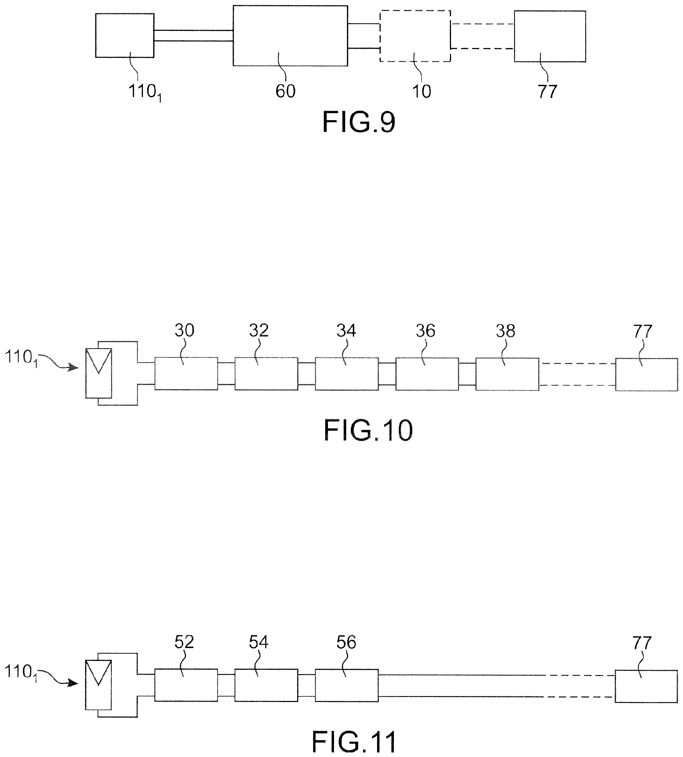

Un exemple de réalisation d'un tel dispositif est illustré en figure 9 : il s'agit d'une réalisation en mode numérique, utilisant une chaîne d'acquisition, comportant l'un des moyens 110₁ de mesure de tension et un convertisseur analogique/numérique 60 qui permet de différencier la signature des autres bruits ambiants. Ce mode de réalisation numérique ne nécessite pas de filtrage. Selon le procédé de calcul utilisé, le convertisseur 60 permet d'échantillonner le signal à une fréquence comprise entre 100 kHz et 5 MHz. Un échantillonnage au voisinage de 100 kHz donc à basse fréquence, est très avantageux en termes de coût. Avantageusement, la fréquence d'échantillonnage est comprise entre 90 kHz et 600 kHz. Des moyens de traitement numérique permettent de calculer les différentes valeurs et de mettre en oeuvre les étapes de traitement selon l'invention.

Des moyens 77 de traitement de données, spécialement programmés à cet effet, pourront permettre de mémoriser et/ou d'analyser les valeurs de tension mesurées pour établir la présence d'un arc parallèle. Ces moyens 77 peuvent par exemple comporter un microprocesseur ou un ordinateur.

D'autres solutions techniques, de type analogique, sont possibles. On cherche alors à isoler la tension mesurée, ou la signature de l'arc électrique, des autres perturbations de la tension observées à l'entrée des moyens de détection de tension. En effet, sur un système PV la tension n'est pas parfaitement lisse, il demeure des perturbations, en particulier à 100Hz, de forme sinusoïdale et d'amplitude variable suivant le niveau de puissance injecté par l'onduleur 10 sur le réseau : ce sont des harmoniques générées par l'onduleur, qui se reportent à son entrée et donc sur la partie continue de l'installation PV. Certaines perturbations peuvent être à plus haute fréquence, par exemple des perturbations de type Dirac, qui représentent des perturbations de démarrage moteur ou de tout autre élément proche de l'installation PV et émettant des perturbations électromagnétiques. Par exemple, un moteur peut se trouver dans un environnement proche de l'installation PV et émettre un champ électromagnétique perturbateur ou être alimenté par la sortie de l'onduleur.

Enfin, des perturbations liées à l'utilisation d'une communication par courant porteur en ligne (CPL) peuvent gêner les moyens de détection de la tension. Ces perturbations peuvent provenir, par exemple, de la présence, dans l'installation PV, de systèmes intelligents et communiquant par courant porteur en ligne (CPL).

Un exemple de réalisation analogique consiste en l'utilisation de filtres passifs analogiques en cascade, comme illustré en figure 10. Sur cette figure, comme sur la suivante, la référence 110₁ désigne l'un des moyens de mesure de tension de la figure 1C ; le même schéma pourrait être reproduit pour chacun des autres moyens de mesure de tension.

Dans cet exemple, le circuit comporte 3 étages : un 1^{er} filtre passif 30 (passe bande), un 2^{ème} filtre passif 32 (passe haut) et un amplificateur 34.

Ces étages peuvent être regroupés en 1 seul. Ces étages peuvent être suivis d'un buffer 36 et de moyens 38 de découplage, pour découpler le module PV du circuit électrique afin de le mettre en sécurité. Le buffer permet de filtrer les rebonds du signal mesuré. Un arc électrique est rarement franc et est constitué d'une multitude d'amorçages avant de stabiliser son plasma : il convient de détecter seulement le premier amorçage.

Les filtres 30, 32 permettent d'isoler la bonne fréquence (avec le temps caractéristique de montée ou de descente ayant les valeurs indiquées précédemment) et donc de rejeter les basses fréquences (de préférence en dessous de 1000 Hz) et les hautes fréquences.

Ce filtrage peut aussi être effectué avec des éléments actifs permettant d'en augmenter la sélectivité (ordre 6 au lieu de l'ordre 1 ou 2 avec le filtrage passif). Le dispositif comporte alors des moyens formant filtre actif (passe haut), des moyens formant amplificateur et comparateur, des moyens formant filtre passif (passe bas), des moyens formant filtre passif (passe bas), un buffer, et des moyens de découplage.

Enfin, une combinaison de moyens analogiques et de moyens numériques est possible, comme illustré en figure 11, comportant :
- des moyens 52 de découplage,
- des moyens 54 formant amplificateur et comparateur,
- des moyens 56 de traitement numérique.

D'autres modes de réalisation sont possibles, par exemple les fonctions d'amplification et de comparaison ne sont pas nécessairement dans un même dispositif 54.

Dans les divers dispositifs analogiques décrits, on détecte la variation de tension et le temps caractéristique (de montée de descente) correspondant, conformément à l'un des procédés décrits ci-dessus, et en particulier :
- grâce au comparateur, pour la variation de tension,
- grâce à la sélectivité des filtres, le temps de montée ou de descente de cette variation, compris entre 0,01 µs et 10 µs (cas d'un arc parallèle) ou entre 0,5 µs et 5 µs (cas d'un arc série).

Globalement, plus on privilégie un système numérique, plus le temps de réponse du dispositif est rapide. Il est intéressant d'avoir un temps de réponse rapide (de quelques dizaines de microsecondes) car il est ainsi possible de limiter l'apparition du plasma d'arc, évitant ainsi des dégradations physiques sur le système. Plus le nombre de composants pour réaliser la fonction est réduit, plus le coût sera réduit, d'où l'intérêt de ne travailler que sur la signature en tension et en analogique (pas en courant ou en RF et avec un traitement numérique lourd derrière).

Pour la figure 7A, les légendes des étapes sont :
S10 : déclenchement de tous les capteurs ?
S11 : arc série en tête ou arc parallèle aux bornes d'une ou plusieurs des chaines
S12 : dV/dt>0?
S13 : arc probablement de type « série »
S14 : arc probablement de type « parallèle»
S15 : - arc série sur une seule chaîne
   - arc série dans module
   - arc parallèle aux bornes d'un module
S20 : tous les capteurs d'une chaine avec dV/dt>0?
S21 : Arc série sur la chaîne concernée
S22 : - arc de type « série » dans un module - arc parallèle aux bornes d'un module
S30 : Vfinale = Varc sur module concerné avec dV/dt<0
S31 : arc de type « série »dans un module où dV/dt<0
S32 : arc parallèle aux bornes d'un module.

Pour la figure7B, les légendes des étapes sont :
S31 : arc de type « série »dans un module où dV/dt<0
S34 : Vfinale = Varc/nmod?
S35 : arc de type « série »dans un module où dV/dt<0
S36 : Arc de type « parallèle » entre l'anode de la diode positionnée en tête de la chaîne concernée et les moyens 10.

## Revendications

1. Procédé pour estimer la nature, série ou parallèle, et la localisation, d'un arc dans un dispositif photovoltaïque, comportant N (N=1 ou N>1) chaines (100, 101) de modules photovoltaïques (100₁ - 100₃, 101₁ - 101₃), reliées à un dispositif de charge (10) présentant un comportement capacitif pour les modules, ce procédé comportant :
a) mesurer, aux bornes de chacun des modules de chaque chaîne (100, 101), l'évolution temporelle de la tension, au moins lors de la formation d'un arc électrique,
b) identifier les modules aux bornes desquels se produit une variation de tension entre une première durée (A) pendant laquelle la tension présente une pente sensiblement stable et une deuxième durée (B) pendant laquelle la tension présente une pente sensiblement stable pendant au moins 5µs, qui suit immédiatement ladite variation de tension, et identifier le sens, positif ou négatif, de chaque variation de tension,
c) estimer la nature, série ou parallèle, et la localisation, de l'arc dans le dispositif photovoltaïque, à partir de l'information sur les modules aux bornes desquels se produit une variation de tension, et le signe de chaque variation de tension.

2. Procédé selon la revendication 1, dans lequel :
- avant l'étape c), on estime l'amplitude de la variation et/ou la durée pendant laquelle cette variation se produit et/ou le taux moyen de cette variation, pour constater la présence effective d'un arc ;
- et/ou lorsque la tension aux bornes de chacun des modules de chaque chaîne varie à la baisse, il est estimé qu'un arc parallèle se produit aux bornes principales (A, B) du dispositif.

3. Procédé selon l'une des revendications 1 ou 2, dans lequel, lorsque la tension aux bornes d'un module d'une des chaînes du dispositif varie à la baisse, tandis que la tension aux bornes de chaque autre module de la même chaîne varie à la hausse, il est estimé qu'un arc parallèle se produit aux bornes dudit module ou qu'un arc série se produit à l'intérieur dudit module.

4. Procédé selon l'une des revendications 1 ou 2, dans lequel :
- lorsque la tension aux bornes d'un module d'une des chaînes du dispositif varie à la baisse vers la valeur de tension d'arc, tandis que la tension aux bornes de chaque autre module de la même chaîne varie à la hausse, il est estimé qu'un arc parallèle se produit aux bornes dudit module ;
- et/ou lorsque la tension aux bornes d'un module d'une des chaînes du dispositif varie à la baisse d'une valeur absolue sensiblement égale à V_{arc}/((1/n_{mod}) -1), où V_{arc} est la tension finale de l'arc, et n_{mod} est le nombre de modules dans la chaîne concernée, tandis que la tension aux bornes de chaque autre module de la même chaîne varie à la hausse, il est estimé qu'un arc série se produit à l'intérieur dudit module ;
- et/ou lorsque la tension aux bornes de chacun des modules de chaque chaîne varie à la hausse, il est estimé qu'un arc série se produit entre l'une des chaînes et ledit dispositif de charge (10) ;
- et/ou lorsque la tension aux bornes de chacun des modules d'une des chaînes (100, 101) varie à la hausse, une variation de tension n'étant pas constatée aux bornes des modules des autres chaînes, il est estimé qu'un arc série se produit à l'intérieur de ladite chaîne, mais pas à l'intérieur d'un des modules de cette même chaîne.

5. Procédé selon l'une des revendications 1 à 4, une diode (130,131) étant présente en tête de chaque chaîne, et dans lequel, lorsque la tension aux bornes de chacun des modules d'une 1^{ère} chaîne (100, 101), varie à la baisse, une variation de tension n'étant pas constatée aux bornes des modules des autres chaînes, il est estimé qu'un arc parallèle se produit entre la diode de la 1^{ère} chaîne et le dispositif de charge (10).

6. Procédé selon l'une des revendications 1 à 5, dans lequel le courant est continu.

7. Dispositif pour estimer la nature, série ou parallèle, et la localisation, d'un arc dans un système photovoltaïque comportant N (N=1 ou N>1) chaines (100, 101) de modules photovoltaïques (100₁ - 100₃, 101₁ - 101₃), reliées à un dispositif de charge (10) présentant un comportement capacitif pour les modules, ce dispositif comportant :
a) des moyens (110₁ - 110₃, 111₁ - 111₃) de détection pour détecter, aux bornes de chacun des modules de chaque chaine (100, 101), l'évolution temporelle de la tension lors de la formation d'un arc électrique,
b) des moyens (77, 202) pour identifier les modules aux bornes desquels au moins une variation de tension se produit, entre une première durée, pendant laquelle la tension présente une pente sensiblement stable et une deuxième durée, d'au moins 5µs, pendant laquelle la tension présente une pente sensiblement stable et qui suit immédiatement ladite variation de tension, et pour identifier le sens, positif ou négatif, de la variation de tension;
c) des moyens (77, 202) pour estimer la nature, série ou parallèle, et la localisation, de l'arc dans le dispositif photovoltaïque, à partir de l'information sur les modules aux bornes desquels se produit une variation de tension, et sur le signe de chaque variation de tension.

8. Dispositif selon la revendication 7, comportant également des moyens pour estimer l'amplitude de ladite variation et/ou la durée pendant laquelle cette variation se produit et/ou le taux moyen de cette variation, afin de constater la présence effective d'un arc.

9. Dispositif selon l'une des revendications 7 ou 8, dans lequel, lorsque les moyens de détection aux bornes de chacun des modules de chaque chaîne détectent une variation temporelle de la tension à la baisse, il est estimé qu'un arc parallèle se produit aux bornes principales (A, B) du dispositif.

10. Dispositif selon l'une des revendications 7 à 9, dans lequel, lorsque les moyens de détection aux bornes d'un module d'une des chaînes du dispositif détectent une variation à la baisse de la tension, tandis que les moyens de détection aux bornes de chaque autre module de la même chaîne détectent une évolution temporelle à la hausse de la tension, il est estimé qu'un arc parallèle se produit aux bornes dudit module, ou qu'un arc série se produit à l'intérieur dudit module.

11. Dispositif selon l'une des revendications 7 à 9, dans lequel :
- lorsque les moyens de détection aux bornes d'un module d'une des chaînes du dispositif détectent une variation temporelle à la baisse de la tension vers la valeur de tension d'arc, tandis que les moyens de détection aux bornes de chaque autre module de la même chaîne détectent une évolution temporelle à la hausse de la tension, il est estimé qu'un arc parallèle se produit aux bornes de celui-ci ;
- ou lorsque les moyens de détection aux bornes d'un module d'une des chaînes du dispositif détectent une variation à la baisse de la tension, d'une valeur absolue sensiblement égale à V_{arc}/((1/n_{mod}) -1), où V_{arc} est la tension finale de l'arc, et n_{mod} est le nombre de modules dans la chaîne concernée, tandis que les moyens de détection aux bornes de chaque autre module de la même chaîne détectent une évolution temporelle à la hausse de la tension, il est estimé qu'un arc série se produit à l'intérieur dudit module ;
- et/ou lorsque les moyens de détection aux bornes de chacun des modules de chaque chaîne détectent une variation à la hausse de la tension, il est estimé qu'un arc série se produit entre l'une quelconque des chaînes et ledit dispositif de charge (10) ;
- et/ou, lorsque les moyens de détection aux bornes de chacun des modules d'une chaîne détectent une variation à la hausse de la tension, tandis que les moyens de détection aux bornes de chaque autre module des autres chaînes ne détectent pas de variation de tension, il est estimé qu'un arc série se produit à l'intérieur d'une des chaînes (100, 101), mais pas à l'intérieur d'un des modules de cette même chaîne.

12. Dispositif selon l'une des revendications 7 à 11, une diode (130,131) étant présente en tête de chaque chaîne, et dans lequel, lorsque la tension aux bornes de chacun des modules d'une 1^{ère} chaîne (100, 101), varie à la baisse, une variation de tension n'étant pas constatée aux bornes des modules des autres chaînes, il est estimé qu'un arc parallèle se produit entre la diode de la 1^{ère} chaîne et le dispositif de charge (10).

13. Dispositif selon l'une des revendications 7 à 12, comportant des moyens de filtrage analogiques et/ou numériques (50, 52, 54) de l'évolution temporelle de la tension.

14. Dispositif selon l'une des revendications 7 à 13, comportant des moyens (60) pour numériser des données d'évolution de tensions.

15. Dispositif selon l'une des revendications 7 à 14, dans lequel le dispositif (10) présentant un comportement capacitif pour les modules comporte un convertisseur ou un onduleur ou une batterie.

## Patentansprüche

1. Verfahren zum Schätzen der Beschaffenheit, seriell oder parallel, sowie der Position eines Lichtbogens in einer Fotovoltaik-Vorrichtung, umfassend N (N=1 oder N>1) Ketten (100, 101) von Fotovoltaik-Modulen (100₁ - 100₃, 101₁ - 101₃), welche mit einer Ladungsvorrichtung (10) verbunden sind, welche für die Module ein kapazitives Verhalten aufweist, das Verfahren umfassend:
a) Messen der zeitlichen Entwicklung der Spannung an den Anschlüssen jedes der Module von jeder Kette (100, 101), wenigstens während des Bildens eines Lichtbogens,
b) Identifizieren der Module, an deren Anschlüssen eine Variation der Spannung auftritt, zwischen einem ersten Zeitraum (A), während welchem die Spannung eine im Wesentlichen stabile Steigung aufweist, und einem zweiten Zeitraum (B), während welchem die Spannung während wenigstens 5 µs eine im Wesentlichen stabile Steigung aufweist, welcher unmittelbar auf die Variation der Spannung nachfolgt, und Identifizieren der Richtung, positiv oder negativ, jeder Variation der Spannung,
c) Schätzen der Beschaffenheit, seriell oder parallel, sowie der Position des Lichtbogens in der Fotovoltaik-Vorrichtung, ausgehend von der Information über die Module, an deren Anschlüssen eine Variation der Spannung auftritt, sowie dem Vorzeichen von jeder Variation der Spannung.

2. Verfahren nach Anspruch 1, wobei:
- vor Schritt c) die Amplitude der Variation und/oder der Zeitraum, während welchem die Variation auftritt, und/oder die mittlere Rate dieser Variation geschätzt wird, um das effektive Vorliegen eines Lichtbogens festzustellen;
- und/oder während die Spannung an den Anschlüssen jedes der Module jeder Kette abnimmt, geschätzt wird, dass ein paralleler Lichtbogen an den Hauptanschlüssen (A, B) der Vorrichtung auftritt.

3. Vorrichtung nach einem der Ansprüche 1 oder 2, wobei während die Spannung an den Anschlüssen eines Module von einer der Ketten der Vorrichtung abnimmt, wohingegen die Spannung an den Anschlüssen von jedem anderen Modul der gleichen Kette zunimmt, geschätzt wird, dass ein paralleler Lichtbogen an den Anschlüssen dieses Moduls auftritt oder dass ein serieller Lichtbogen im Inneren des Moduls auftritt.

4. Verfahren nach einem der Ansprüche 1 oder 2, wobei:
- wenn die Spannung an den Anschlüssen eines Moduls von einer der Ketten der Vorrichtung in Richtung des Werts der Spannung des Lichtbogens abnimmt, wohingegen die Spannung an den Anschlüssen von jedem anderen Modul der gleichen Kette zunimmt, geschätzt wird, dass ein paralleler Lichtbogen an den Anschlüssen dieses Moduls auftritt;
- und/oder wenn die Spannung an den Anschlüssen eines Moduls von einer der Ketten der Vorrichtung von einem Absolutwert, welcher im Wesentlichen gleich V_{arc}/((1/n_{mod})-1) ist, wobei V_{arc} die Endspannung des Lichtbogens ist und n_{mod} die Anzahl von Modulen in der betreffenden Kette ist, abnimmt, wohingegen die Spannung an den Anschlüssen von jedem anderen Modul der gleichen Kette zunimmt, geschätzt wird, dass ein serieller Lichtbogen im Inneren des Moduls auftritt;
- und/oder wenn die Spannung an den Anschlüssen von jedem der Module von jeder Kette zunimmt, geschätzt wird, dass ein serieller Lichtbogen zwischen einer der Ketten und der Ladungsvorrichtung (10) auftritt;
- und/oder wenn die Spannung an den Anschlüssen von jedem der Module von einer der Ketten (100, 101) zunimmt, eine Variation der Spannung an den Anschlüssen von Modulen von anderen Ketten nicht festgestellt wird, geschätzt wird, dass ein serieller Lichtbogen im Inneren der Kette auftritt, nicht jedoch im Inneren eines der Module derselben Kette.

5. Verfahren nach einem der Ansprüche 1 bis 4, wobei eine Diode (130, 131) am Anfang jeder Kette vorliegt und wobei wenn die Spannung an den Anschlüssen von jedem der Module einer ersten Kette (100, 101) abnimmt, eine Variation der Spannung an Anschlüssen von Modulen von anderen Ketten nicht festgestellt wird, geschätzt wird, dass ein paralleler Lichtbogen zwischen der Diode der ersten Kette und der Ladungsvorrichtung (10) auftritt.

6. Verfahren nach einem der Ansprüche 1 bis 5, wobei der Strom kontinuierlich ist.

7. Vorrichtung zum Schätzen der Beschaffenheit, seriell oder parallel, sowie der Position eines Lichtbogens in einem Fotovoltaik-System, umfassend N (N=1 oder N>1) Ketten (100, 101) von Fotovoltaik-Modulen (100₁ - 100₃, 101₁ - 101₃), welche mit einer Ladungsvorrichtung (10) verbunden sind, welche für die Module ein kapazitives Verhalten aufweist, die Vorrichtung umfassend:
a) Detektionsmittel (110₁ - 110₃, 111₁ - 111₃) zum Detektieren der zeitlichen Entwicklung der Spannung an den Anschlüssen jedes der Module von jeder Kette (100, 101), während des Bildens eines Lichtbogens,
b) Mittel (77, 202) zum Identifizieren der Module, an deren Anschlüssen eine Variation der Spannung auftritt, zwischen einem ersten Zeitraum, während welchem die Spannung eine im Wesentlichen stabile Steigung aufweist, und einem zweiten Zeitraum von wenigstens 5 µs, während welchem die Spannung eine im Wesentlichen stabile Steigung aufweist und welcher unmittelbar auf die Variation der Spannung nachfolgt, und zum Identifizieren der Richtung, positiv oder negativ, der Variation der Spannung,
c) Mittel (77, 202) zum Schätzen der Beschaffenheit, seriell oder parallel, sowie der Position des Lichtbogens in der Fotovoltaik-Vorrichtung, ausgehend von der Information über die Module, an deren Anschlüssen eine Variation der Spannung auftritt, sowie dem Vorzeichen von jeder Variation der Spannung.

8. Vorrichtung nach Anspruch 7, ferner umfassend Mittel zum Schätzen der Amplitude der Variation und/oder des Zeitraums, während welchem die Variation auftritt, und/oder der mittleren Rate dieser Variation, um das effektive Vorliegen eines Lichtbogens festzustellen.

9. Vorrichtung nach einem der Ansprüche 7 oder 8, wobei wenn die Detektionsmittel an den Anschlüssen jedes der Module jeder Kette eine abnehmende zeitliche Variation der Spannung detektieren, geschätzt wird, dass ein paralleler Lichtbogen an den Hauptanschlüssen (A, B) der Vorrichtung auftritt.

10. Vorrichtung nach einem der Ansprüche 7 bis 9, wobei wenn die Detektionsmittel an den Anschlüssen eines Moduls von einer der Ketten der Vorrichtung eine abnehmende Variation der Spannung detektieren, wohingegen die Detektionsmittel an den Anschlüssen von jedem anderen Modul der selben Kette eine ansteigende zeitliche Entwicklung der Spannung detektieren, geschätzt wird, dass ein paralleler Lichtbogen an den Anschlüssen dieses Moduls auftritt oder dass ein serieller Lichtbogen im Inneren des Moduls auftritt.

11. Vorrichtung nach einem der Ansprüche 7 bis 9, wobei:
- wenn die Detektionsmittel an den Anschlüssen eines Moduls von einer der Ketten der Vorrichtung eine abnehmende zeitliche Variation der Spannung des Lichtbogens in Richtung des Werts der Spannung detektieren, wohingegen die Detektionsmittel an den Anschlüssen von jedem anderen Modul der selben Kette eine zunehmende zeitliche Entwicklung der Spannung detektieren, geschätzt wird, dass ein paralleler Lichtbogen an den Anschlüssen davon auftritt;
- oder wenn die Detektionsmittel an den Anschlüssen eines Moduls von einer der Ketten der Vorrichtung eine abnehmende Variation der Spannung detektieren, von einem Absolutwert, welcher im Wesentlichen gleich V_{arc}/((1/n_{mod})-1) ist, wobei V_{arc} die Endspannung des Lichtbogens ist und n_{mod} die Anzahl von Modulen in der betreffenden Kette ist, wohingegen die Detektionsmittel an den Anschlüssen von jedem anderen Modul der selben Kette eine ansteigende zeitliche Entwicklung der Spannung detektieren, geschätzt wird, dass ein serieller Lichtbogen im Inneren des Moduls auftritt;
- und/oder wenn die Detektionsmittel an den Anschlüssen jedes der Module von jeder Kette eine ansteigende Variation der Spannung detektieren, geschätzt wird, dass ein serieller Lichtbogen zwischen einer der Ketten und der Ladungsvorrichtung (10) auftritt;
- und/oder wenn die Detektionsmittel an den Anschlüssen von jedem der Module einer Kette eine ansteigende Variation der Spannung detektieren, wohingegen die Detektionsmittel an den Anschlüssen von jedem anderen Modul der anderen Ketten keine Variation der Spannung detektieren, geschätzt wird, dass ein serieller Lichtbogen im Inneren einer der Ketten (100, 101) auftritt, nicht jedoch im Inneren eines der Module derselben Kette.

12. Vorrichtung nach einem der Ansprüche 7 bis 11, wobei eine Diode (130, 131) am Anfang jeder Kette vorliegt und wobei wenn die Spannung an den Anschlüssen von jedem der Module einer ersten Kette (100, 101) abnimmt, eine Variation der Spannung an Anschlüssen von Modulen von anderen Ketten nicht festgestellt wird, geschätzt wird, dass ein paralleler Lichtbogen zwischen der Diode der ersten Kette und der Ladungsvorrichtung (10) auftritt.

13. Vorrichtung nach einem der Ansprüche 7 bis 12, umfassend analoge und/oder digitale (50, 52, 54) Filtermittel für die zeitliche Entwicklung der Spannung.

14. Vorrichtung nach einem der Ansprüche 7 bis 13, umfassend Mittel (60) zum Digitalisieren von Daten der Entwicklung der Spannungen.

15. Vorrichtung nach einem der Ansprüche 7 bis 14, wobei die Vorrichtung (10), welche ein kapazitives Verhalten für die Module aufweist, einen Konverter oder einen Wechselrichter oder eine Batterie umfasst.

## Claims

1. Method for estimating the series or parallel nature and the location of an arc in a photovoltaic device, comprising N (N=1 or N>1) strings (100, 101) of photovoltaic modules (100₁ - 100₃, 101₁ - 101₃), connected to a charge device (10) having a capacitive behaviour for the modules, said method comprising:
a) measuring, at the terminals of each of the modules of each string (100, 101), the evolution of the voltage over time, at least during the formation of an electric arc,
b) identifying the modules at the terminals of which a voltage variation occurs between a first duration (A) during which the voltage has a substantially stable slope and a second duration (B) during which the voltage has a substantially stable slope for a duration of at least 5 µs, which immediately follows said voltage variation, and identifying the positive or negative direction of each voltage variation,
c) estimating the series or parallel nature and the location of the arc in the photovoltaic device, based on the information on the modules at the terminals of which a voltage variation occurs, and the sign of each voltage variation.

2. Method according to claim 1, wherein,
- before step c), the magnitude of the variation and/or the duration during which this variation occurs and/or the mean rate of this variation is/are estimated, in order to observe the effective presence of an arc;
- and/or wherein, when the voltage at the terminals of each of the modules of each string decreases, one concludes that a parallel arc is occurring across the main terminals (A, B) of the device.

3. Method according to one of claims 1 or 2, wherein, when the voltage at the terminals of a module of one of the strings of the device decreases, when the voltage at the terminals of all other modules of the same string increases, one concludes that a parallel arc is occurring across the terminals of said module or that a series arc is occurring within said module.

4. Method according to one of claims 1 to 3, wherein:
- when the voltage at the terminals of one module of one of the strings of the device decreases to the arc voltage value, whereas the voltage at the terminals of each other module of said string increases, one concludes that a parallel arc is occurring across the terminals of said module;
- and/or wherein, when the voltage at the terminals of said module decreases from an absolute value substantially equal to V_{arc} /((1/n_{mod}) -1), where V_{arc} is the final voltage of the arc, and n_{mod} is the number of modules in the string concerned, whereas the voltage at the terminals of each other module of said string increases, one concludes that a series arc is occurring within said module;
- and/or wherein, when the voltage at the terminals of each of the modules of each string increases, one concludes that a series arc is occurring between one of the strings and said charge device (10);
- and/or wherein, when the voltage at the terminals of each of the modules of one of the strings (100, 101) increases, wherein a voltage variation is not observed at the terminals of the modules of the other strings, one concludes that a series arc is occurring within said string, however not within one of the modules of said string.

5. Method according to one of claims 1 to 4, wherein a diode (130, 131) is present at the head of each string, and wherein, when the voltage at the terminals of each of the modules of a first string (100, 101) decreases, and wherein a voltage variation is not observed at the terminals of the modules of the other strings, one concludes that a parallel arc is occurring between the diode of the first string and the charge device (10).

6. Method according to one of claims 1 to 5, wherein the current is a direct current.

7. Device for estimating the series or parallel nature and the location of an arc in a photovoltaic system, comprising N (N=1 or N>1) strings (100, 101) of photovoltaic modules (100₁ - 100₃, 101₁ - 101₃), connected to a charge device (10) having a capacitive behaviour for the modules, said device comprising:
a) detection means (110₁ - 110₃, 111₁ - 111₃) for detecting, at the terminals of each of the modules of each string (100, 101), the evolution of the voltage over time during the formation of an electric arc,
b) means (77, 202) for identifying the modules at the terminals of which at least one voltage variation occurs, between a first duration during which the voltage has a substantially stable slope and a second duration of at least 5 µs, during which the voltage has a substantially stable slope and which immediately follows said voltage variation, and for identifying the positive or negative direction of the voltage variation,
c) means (77, 202) for estimating the series or parallel nature and the location of the arc in the photovoltaic device, based on the information on the modules at the terminals of which a voltage variation occurs, and on the sign of each voltage variation.

8. Device according to claim 7, further comprising means for estimating the magnitude of said variation and/or the duration during which this variation occurs and/or the mean rate of this variation, in order to observe the effective presence of an arc.

9. Device according to one of claims 7 or 8, wherein, when the detection means at the terminals of each of the modules of each string detect a voltage decrease over time, one concludes that a parallel arc is occurring across the main terminals (A, B) of the device.

10. Device according to one of claims 7 to 9, wherein, when the detection means at the terminals of one module of one of the strings of the device detect a voltage decrease, when the detection means at the terminals of all other modules of the same string detect a voltage increase over time, one concludes that a parallel arc is occurring across the terminals of said module or that a series arc is occurring within said module.

11. Device according to one of claims 7 to 9, wherein:
- when the detection means at the terminals of one module of one of the strings of the device detect a voltage decrease over time to the arc voltage value, whereas the detection means at the terminals of each other module of said string detect a voltage increase over time, one concludes that a parallel arc is occurring across the terminals of said module;
- or, when the detection means at the terminals of one module of one of the strings of the device detect a voltage decrease over time from an absolute value substantially equal to V_{arc}/((1/n_{mod}) -1), where V_{arc} is the final voltage of the arc, and n_{mod} is the number of modules in the string concerned, whereas the detection means at the terminals of each other module of said string detect a voltage increase over time, one concludes that a series arc is occurring within said module;
- and/or wherein, when the detection means at the terminals of each of the modules of each string detect a voltage increase, one concludes that a series arc is occurring between any one of the strings and said charge device (10);
- and/or wherein, when the detection means at the terminals of each of the modules of a string detect a voltage increase, when the detection means at the terminals of all other modules of the other strings do not detect a voltage variation, one concludes that a series arc is occurring within one of the strings (100, 101), however not within one of the modules of said string.

12. Device according to one of claims 7 to 11, wherein a diode (130, 131) is present at the head of each string, and wherein, when the voltage at the terminals of each of the modules of a first string (100, 101) decreases, and wherein a voltage variation is not observed at the terminals of the modules of the other strings, one concludes that a parallel arc is occurring between the diode of the first string and the charge device (10).

13. Device according to one of claims 7 to 12, comprising means (50, 52, 54) for the analogue and/or digital filtering of the evolution of the voltage over time.

14. Device according to one of claims 7 to 13, comprising means (60) for digitising the voltage evolution data.

15. Device according to one of claims 7 to 14, wherein the device (10) having a capacitive behaviour for the modules includes a converter, an inverter or a battery.
